Europäisches Patentamt

(19) European Patent Office

Office européen des brevets

(11) Publication number: **0 252 931 B1**

(12) # EUROPEAN PATENT SPECIFICATION

(45) Date of publication of patent specification :
27.03.91 Bulletin 91/13

(51) Int. Cl.⁵: **H03K 19/00, H03K 19/094**

(21) Application number: 86907216.5

(22) Date of filing : 24.11.86

(86) International application number:
PCT/US86/02532

(87) International publication number:
WO 87/03758 18.06.87 Gazette 87/13

(54) **TEMPERATURE COMPENSATED CMOS TO ECL LOGIC LEVEL TRANSLATOR.**

(30) Priority: 16.12.85 US 809108

(43) Date of publication of application:
20.01.88 Bulletin 88/03

(45) Publication of the grant of the patent:
27.03.91 Bulletin 91/13

(84) Designated Contracting States:
DE FR GB

(56) References cited:
US-A- 4 430 582
US-A- 4 453 095

(73) Proprietor: NCR CORPORATION
World Headquarters
Dayton, Ohio 45479 (US)

(72) Inventor: LAUFFER, Donald, Keith
12902 Via del Toro
Poway, CA 92064 (US)
Inventor: SANWO, Ikuo, Jimmy
939 Lacebark Street
San Marcos, CA 92069 (US)

(74) Representative: Robinson, Robert George
International Patent Department NCR Limited
206 Marylebone Road
London NW1 6LY (GB)

EP 0 252 931 B1

## Description

### Technical Field

This invention relates to CMOS to ECL interface circuits of the kind including : input means adapted to receive CMOS logic level signals ; interfacing means comprising CMOS field effect transistors and coupled to said input means and adapted to translate said CMOS logic level signals to ECL logic level signals and including a pair of supply voltage terminals ; and output means adapted to supply said ECL logic level signals to serviced ECL logic devices.

### Background Art

To couple a CMOS circuit to an ECL circuit the difference between the output voltages from the one circuit and the input voltages needed by the second circuit must be generated by some form of interfacing circuit. The logic level "1" of a CMOS circuit will approach the power supply value, which may be about $-3$ volts, and the logic level "0" will be near the reference or ground level. On the other hand, the logic level "1" of an ECL circuit will approach $-0.8$ volts and the logic level "0" will approach $-1.6$ volts. If the interfacing circuit derives its power from the CMOS circuit any difference in temperature between the CMOS and the ECL circuit can cause a variance in the response level of the ECL circuit due to the shifts in electrical characteristics as a function of temperature.

U.S. Patent No. 4,453,095 discloses a CMOS to ECL interface circuit for a five volt CMOS logic swing, including a CMOS inverter having an output coupled to the base electrode of an NPN transistor, which provides an ECL logic swing output at the emitter, which is coupled via a termination resistor to a voltage supply source. The U.S. Patent also discloses an interface circuit for a CMOS logic circuit having a two volt CMOS logic swing, including a CMOS inverter having an output connected to one input of a differential pair of bipolar transistors. The differential pair has an output connected to the base of a bipolar transistor whose emitter provides the desired ECL output.

U.S. Patent No. 4,533,842 discloses a logic level translator for converting TTL logic levels to ECL logic levels incorporating a temperature compensating circuit. The logic level translator includes a differential pair of bipolar transistors, the base electrode of one transistor of the pair being supplied with a threshold voltage. The threshold voltage is supplied by a bandgap reference voltage generator which utilizes resistors having positive and negative temperature coefficients, whereby the generated threshold voltage is rendered independent of temperature.

### Disclosure of the Invention

It is an object of the present invention to provide a CMOS to ECL interface circuit of the kind specified, adapted to compensate for temperature variations.

Therefore, according to the present invention, there is provided a CMOS to ECL interface circuit of the kind specified, characterized by ECL circuit means located in the same temperature environment as said serviced ECL logic devices and including an ECL logic gate formed by an unused one of said serviced logic devices and having complementary first and second outputs connected respectively to said first and second supply voltage terminals, to provide said supply voltages for said interfacing means, whereby said supply voltages track the variations of ECL output logic level of said serviced ECL logic devices as a function of temperature.

### Brief Description of the Drawings

One embodiment of the present invention will now be described by way of example, with reference to the accompanying drawings, in which :
Fig. 1 is a circuit diagram of the preferred embodiment of the invention ; and
Fig. 2 is a table indicating the typical voltage conditions present at like labeled parts of the circuit of Fig. 1.

### Best Mode for Carrying Out the Invention

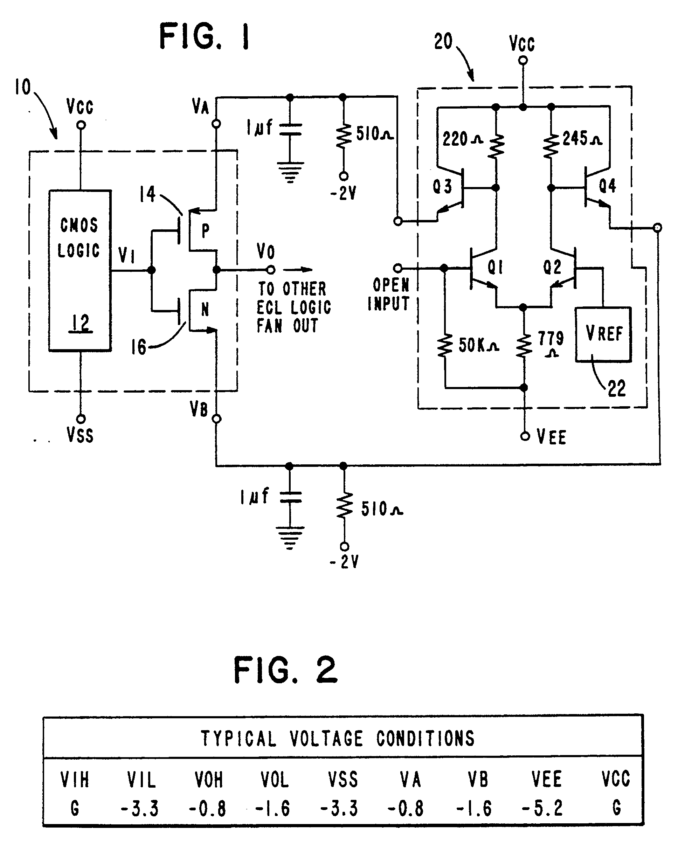

Referring to Fig. 1, a CMOS logic device 10 is adapted to be connected to service ECL logic devices in a fan out fashion via an output terminal $V_0$. A CMOS logic circuit 12 is connected between a reference potential VCC and a supply voltage VSS to provide at its output a CMOS logic level signal denoted V1, which signal has two logic states with voltage levels of 0 volts and $-3.3$ volts, respectively. An interfacing circuit, comprised of complementary field effect transistors 14 and 16, which may be formed using discrete devices or as part of the CMOS logic device 10, receives the signal V1 and translates the signal to corresponding ECL logic level signals. The signal V1 is coupled to the gates of transistors 14 and 16, which transistors have their source-drain paths connected in series between a pair of supply voltage terminals VA and VB. The terminal $V_0$ is connected to the junction point between the source-drain paths of the transistors 14, 16.

In order to drive an ECL logic circuit the voltages appearing on the terminal $V_0$ should, for the two logic states, have the values of $-0.8$ volts and $-1.6$ volts corresponding to the ECL "high" and "low" logic levels respectively. Because the voltage responses of the serviced ECL logic devices, coupled to the output $V_0$, vary somewhat as a function of temperature it is most desirable to have the voltages representing the logic levels vary in a directly proportional manner with the voltage responses of the serviced ECL logic circuits. In the present embodiment, this is accomplished by using one of the unused ECL logic gates that is exposed to the same temperature environment as the other ECL logic gates serviced by the CMOS device 10.

Although various logic gates may be utilized to accomplish the same function, namely that of providing an output voltage which varies as a direct function of temperature, an OR-NOR gate is shown in the preferred exemplary embodiment. In the preferred embodiment, the OR-NOR gate is provided with a reference (ground) terminal VCC and a terminal VEE for receiving a – 5.2 volt supply voltage. Four transistors of the NPN type, labeled Q1 through Q4, form the OR-NOR gate and are connected such that the emitter of Q3, which is the NOR output, is connected to the terminal VA with the emitter of Q4, which is the OR output, being connected to the terminal VB. The emitters of transistors Q1 and Q2 are connected by means of a 779 ohm resistor to the VEE supply. A reference potential source 22, having a value of – 1.3 volts, is connected to the base of transistor Q2. The base of transistor Q1 is connected by means of a 50 K ohm resistor to the terminal VEE. A 220 ohm biasing resistor connects the collector and base of transistor Q1 and Q3, respectively, to the reference potential VCC. In a like manner a biasing resistor of 245 ohms connects the base of transistor Q4 and the collector of transistor Q2 to the reference potential VCC. Two 510 ohm resistors are connected, one each, to the conductors connected to the terminals VA and VB at one end and at the other end to a – 2 volt power supply. Two 1 microfarad capacitors are also connected, one each, between the conductors and ground.

In operation, the transistor Q3 is biased ON with a one diode voltage drop appearing between its base and its emitter which thereby places a voltage of approximately – 0.8 volts at the terminal VA. The base of transistor Q1 is held opened and is connected by a 50 K ohm resistor to the – 5.2 volt supply VEE. The transistor Q1 is maintained in an OFF condition. Transistor Q3 is biased ON by the VREF supply of – 1.3 volts which is more positive then the – 5.2 volt VEE supply. With transistor Q2 ON, collector current through the 245 ohm resistor develops a potential of approximately – 0.8 volts at the base of transistor Q4, thus turning Q4 on since it has a one diode voltage drop between its base and emitter. The emitter current of transistor Q4, flowing through the 510 ohm resistor, causes a voltage of – 1.6 volts to appear at the terminal VB.

Fig. 2 is a chart which lists the voltage levels appearing at like designated locations on the circuit of Fig. 1. VIH corresponds to the "high" logic level of the signal appearing at the output of the CMOS logic cir-

cuit 12. VIL corresponds to the "low" logic level. In a like manner, the voltage levels VOH and VOL correspond to the "high" and "low" voltage levels on the output of $V_0$.

The use of the complementary outputs of the unused ECL logic NOR circuit to provide the voltages VA and VB alleviates the temperature tracking problem as VA and VB will automatically track the variations of the ECL output logic level as a function of temperature.

## Claims

1. A CMOS to ECL interface circuit, including : input means adapted to receive CMOS logic level signals ; interfacing means (14, 16) comprising CMOS field effect transistors and coupled to said input means and adapted to translate said CMOS logic level signals to ECL logic level signals and including a pair of supply voltage terminals (VA, VB) ; and output means adapted to supply said ECL logic level signals to serviced ECL logic devices, characterized by ECL circuit means (20) located in the same temperature environment as said serviced ECL logic devices and including an ECL logic gate (20) formed by an unused one of said serviced logic devices and having complementary first and second outputs connected respectively to said first and second supply voltage terminals (VA, VB), to provide said supply voltages for said interfacing means (14, 16), whereby said supply voltages track the variations of ECL output logic level of said serviced ECL logic devices as a function of temperature.

2. A CMOS to ECL interface circuit according to claim 1, characterized in that said ECL logic gate is an ECL OR/NOR gate (20).

3. A CMOS to ECL interface circuit according to claim 2, characterized in that said first output is an OR output and is adapted to supply a low ECL logic level signal and said second output is a NOR output and is adapted to supply a high ECL logic level signal.

4. A CMOS to ECL interface circuit according to claim 3, characterized in that a pair of resistors are respectively coupled between said OR and NOR outputs and a source of supply potential.

5. A CMOS to ECL interface circuit according to claim 4, characterized in that a pair of capacitors are connected between ground and said pair of supply voltage terminals (VA, VB).

6. A CMOS to ECL interface circuit according to claim 1, characterized in that said interfacing means includes a pair of complementary field effect transistors (14, 16) having their source-drain paths connected in series between said supply voltage terminals (VA, VB), in that the gate electrodes of said pair of transistors (14, 16) are connected in common to said input means and in that the junction point between the source-drain paths of said pair of transistors (14, 16) is connected to said output means.

## Ansprüche

1. Eine CMOS-zu-ECL-Schnittstellenschaltung mit : Eingangsvorrichtungen, die geeignet sind zum Empfang von CMOS-Logikpegelsignalen ; Schnittstellenvorrichtungen (14, 16), die CMOS-Feldeffekttransistoren aufweisen und mit den Eingangsvorrichtungen gekoppelt und geeignet sind, die CMOS-Logikpegelsignale in ECL-Logikpegelsignale umzusetzen, und ein Paar Versorungsspannungsklemmen (VA, VB) aufweisen ; und Ausgangsvorrichtungen, die geeignet sind, die ECL-Logikpegelsignale bedienten ECL-Logikvorrichtungen zuzuführen, gekennzeichnet durch eine ECL-Schaltungsvorrichtung (20), die in der gleichen Temperaturumgebung angeordnet ist wie die bedienten ECL-Logikvorrichtungen und ein ECL-Logiktor (20) aufweisen, das gebildet wird durch eine nicht verwendete der bedienten Logikvorrichtungen und dessen komplementäre erste und zweite Ausgänge entsprechend verbunden sind mit der ersten und zweiten Versorgungsspannungsklemme (VA, VB), um die Versorgungsspannungen für die Schnittstellenvorrichtungen (14, 16) abzugeben, wobei die Versorgungsspannungen den Variationen des ECL-Ausgangslogikpegels der bedienten ECL-Logikvorrichtungen als Funktion der Temperatur folgen.

2. Eine CMOS-zu-ECL-Schnittstellenschaltung nach Anspruch 1, dadurch gekennzeichnet, daß das ECL-Logiktor ein ECL-ODER/NODER-Glied (20) ist.

3. Eine CMOS-zu-ECL-Schnittstellenschaltung nach Anspruch 2, dadurch gekennzeichnet, daß der erste Ausgang ein ODER-Ausgang ist und geeignet ist, ein niedriges ECL-Logikpegelsignal abzugeben, und daß der zweite Ausgang ein NODER-Ausgang ist und geeignet ist, ein hohes ECL-Logikpegelsignal abzugeben.

4. Eine CMOS-zu-ECL-Schnittstellenschaltung nach Anspruch 4, dadurch gekennzeichnet, daß ein Paar von Widerständen entsprechend zwischen den ODER- und den NODER-Ausgang und eine Quelle von Versorgungspotential gekoppelt ist.

5. Eine CMOS-zu-ECL-Schnittstellenschaltung nach Anspruch 4, dadurch gekennzeichnet, daß ein Paar von Kondensatoren zwischen Erde und das Paar von Versorgungsspannungsklemmen (VA, VB) gekoppelt ist.

6. Eine CMOS-zu-ECL-Schnittstellenschaltung nach Anspruch 1, dadurch gekennzeichnet, daß die Schnittstellenvorrichtungen ein Paar von komplementären Feldeffekttransistoren (14, 16) aufweisen, deren Source-Drain-Strecken in Reihe zwischen die Versorgungsspannungsklemmen (VA, VB) geschaltet sind, daß die Gate-Elektroden des Paares von Transistoren (14, 16) gemeinsam an die Eingangsvorrichtung angeschlossen sind und daß der Verbindungspunkt zwischen den Source-Drain-Strecken des Paares von Transistoren (14, 16) mit der Ausgangsvorrichtung verbunden ist.

## Revendications

1. Circuit d'interface CMOS en ECL, comprenant: des moyens d'entrée destinés à recevoir des signaux de niveau logique CMOS ; des moyens d'interface (14, 16) comportant des transistors à effet de champ CMOS couplés auxdits moyens d'entrée et destinés à translater lesdits signaux de niveau logique CMOS en signaux de niveau logique ECL et comprenant une paire de bornes de tension d'alimentation (VA, VB) ; et des moyens de sortie destinés à appliquer lesdits signaux de niveau logique ECL à des dispositifs à logique ECL desservis, caractérisé par des moyens à circuit ECL (20) placés dans un environnement à même température que lesdits dispositifs logiques ECL desservis et comprenant une porte logique ECL (20) formée par l'un, inutilisé, desdits dispositifs logiques desservis et ayant des première et seconde sorties complémentaires connectées, respectivement, auxdites première et seconde bornes de tensions d'alimentation (VA, VB), pour produire lesdites tensions d'alimentation pour lesdits moyens d'interface (14, 16), afin que lesdites tensions d'alimentation suivent les variations du niveau logique de sortie ECL desdits dispositifs logiques ECL desservis en fonction de la température.

2. Circuit d'interface CMOS en ECL selon la revendication 1, caractérisé en ce que ladite porte logique ECL est une porte OU/NON-OU ECL (20).

3. Circuit d'interface CMOS en ECL selon la revendication 2, caractérisé en ce que ladite première sortie est une sortie OU et est destinée à fournir un signal de niveau logique ECL bas et ladite seconde sortie est une sortie NON-OU et est destinée à fournir un signal de niveau logique ECL haut.

4. Circuit d'interface CMOS en ECL selon la revendication 1, caractérisé en ce que deux résistances sont couplées respectivement entre lesdites sorties OU et NON-OU et une source de potentiel d'alimentation.

5. Circuit d'interface CMOS en ECL selon la revendication 4, caractérisé en ce que deux condensateurs sont connectés entre la masse et ladite paire de bornes à tension d'alimentation (VA, VB).

6. Circuit d'interface CMOS en ECL selon la revendication 1, caractérisé en ce que lesdits moyens d'interface comprennent deux transistors à effet de champ complémentaires (14, 16) dont les circuits source-drain sont montés en série entre lesdites bornes à tension d'alimentation (VA, VB), en ce que les électrodes de grille desdits deux transistors (14, 16) sont connectées en commun auxdits moyens d'entrée et en ce que le point de jonction entre les circuits source-drain desdits deux transistors (14, 16) est connecté auxdits moyens de sortie.

# FIG. 1

# FIG. 2

| TYPICAL VOLTAGE CONDITIONS | | | | | | | | |
|------|------|------|------|------|------|------|------|------|
| VIH | VIL | VOH | VOL | VSS | VA | VB | VEE | VCC |
| G | -3.3 | -0.8 | -1.6 | -3.3 | -0.8 | -1.6 | -5.2 | G |